# EUROPEAN PATENT APPLICATION

(11) **EP 4 814 159 A1**
(43) Date of publication of application: **30.09.2026**
(21) Application number: 26166980.8
(22) Date of filing: 24.03.2026
(51) Int. Cl.: C23C 16/32, C23C 16/44

(54) **ETCHING OF SILICON CARBIDE ACCRETIONS FROM REACTOR PARTS**

(30) Priority: 27.03.2025 IT 202500006468
(71) Applicant: LPE S.p.A., 20021 Baranzate (MI) (IT); ASM IP Holding B.V., 1322 AP Almere (NL)
(72) Inventor: VALENTE, Gianluca, Milano (IT); REITER, Steven, Phoenix, Arizona (US); DEMOS, Alexandros, Scottsdale, Arizona (US); MAUCERI, Marco, Catania (IT)
(74) Representative: Buzzi, Notaro & Antonielli d'Oulx S.p.A.

(57) **Abstract**

The present invention relates to a method for etching a silicon carbide accretion from one or more workpieces of a reaction chamber for the deposition of silicon carbide layers on a substrate. The method comprises the steps of: (i) providing a silicon carbide accretion on one or more workpieces of a reaction chamber of a reactor for deposition silicon carbide; (ii) executing at least one cycle of an etching process; (iii) executing at least one cycle of a chemical vapor deposition process. The present invention further relates to a reactor adapted to execute said method.

## Description

### FIELD OF INVENTION

The present invention relates to the field of epitaxial deposition of semiconductor films on substrates; in particular to a method and to a reactor adapted to execute a chemical etching of silicon carbide from reactor parts.

### BACKGROUND OF THE DISCLOSURE

During an epitaxial deposition process, one or more monocrystalline semiconductor layers grow in a controlled fashion on one or more rotating substrates placed in a reaction chamber of a reactor. However, during this process, undesired semiconductor accretions may also grow on other parts of the reaction chamber exposed to process gases.

For example, during the epitaxial deposition of monocrystalline silicon carbide on a substrate, for instance the epitaxial deposition of 3C, 4H or 6H silicon carbide polytypes, users typically observe uncontrolled silicon carbide build-up on several structural and functional parts of the reaction chamber. It is noted that this undesired silicon carbide build-up is difficult to remove because of the hardness of the material, and conventional techniques used in the silicon semiconductor industry do not suitably apply to the removal of silicon carbide.

Contrary to the orderly monocrystalline layers deposited on the substrate, silicon carbide build-up generally comprises silicon carbide in polycrystalline and/or amorphous form. Typically, it is a mixture of both polycrystalline and amorphous silicon carbide. The latter may compose up to 20 - 60% of the total, as can be observed in XRD measurements, though the relative ratio of the two forms may greatly vary, both locally and/or on average.

The above parasitic phenomenon is particularly relevant in hot-wall reactors, where it is prevalently impacting the upstream end of the chamber (i.e., where the precursor gases enter the reaction chamber), as well as the elements surrounding or in contact with the substrate.

It is noted that undesired SiC buildup does not occur only on bare surfaces of the reaction chamber but also on those parts that are preventively coated.

Indeed, graphite chamber parts may be acquired coated with a TaC layer to protect the graphite surfaces during cleaning operations. Alternatively, a thin coating of SiC may be used to seal the exposed porous graphite surfaces to avoid contamination. In this case, the SiC coating used on the graphite parts is in polycrystalline form, with a smooth external surface featuring a surface roughness below 6,3 µm Ra, more typically below 1 µm Ra.

It has been observed that the parasitic deposition of SiC accretions on reaction chamber parts often results in the rapid growth of cauliflower-like, porous, dendritic-like structures, which eventually affect the quality of the deposited layers on the semiconductor substrates. These parasitic accretions have an uneven appearance, with macroscopic rugosity.

In order to prevent the negative effects of parasitic films on the deposition process, the reaction chamber is subject to frequent Preventive Maintenance (PM) operations, for instance after every 100 µm to 2000 µm of total epitaxial layers growth.

During PM, the machine is cooled and purged, and some or all affected parts are manually removed from the chamber for mechanical cleaning, disposal, and/or substitution.

PM operations negatively impact the productivity of the reactor, thereby heavily affecting the economics of the epitaxial deposition process. Indeed, PM operations may cause several hours of reactor downtime and occur multiple times per week/month.

In Si reactors, in-situ or ex-situ chemical etching processes are known and used to remove undesired Si parasitic deposits. These methods allow more reproducible results than their mechanical cleaning counterparts. Additionally, in-situ etching processes can be performed without the need to open and access the reaction chamber, advantageously reducing reactor downtime and streamlining operations.

However, silicon carbide exhibits very different chemical and physical properties compared to silicon. It is a much harder material, difficult to attack via chemical means without eventually damaging the concerned reactor parts and/or introducing potential contaminants into the chamber.

It is noted that in-situ etching is generally conducted using chemicals that react with the parasitic deposition, leading to gas phase byproducts. In case of Silicon Carbide, this process may lead to solid, powder-like byproducts.

Powder byproducts of the etching process may be difficult to remove without significant extension of etching times, which may end up damaging the underlying chamber parts and affect the downtime of the reactor.

While methods for etching SiC have been disclosed in the art, these methods typically discuss the removal of a few top layers of orderly SiC from bulk SiC pieces, such as described in US20140030892A1 and US20060001028A1. The chemical etching of SiC in these instances takes place in the absence of an underlying part (of potentially different composition) that may be damaged in the process. These processes typically remove only few microns of SiC to respectively reduce warpage of monocrystalline SiC substrates and surface cracks of SiC substrate holders. These methods do not address the removal of disorderly parasitic SiC deposits without detriment to the affected reaction chamber parts.

It is therefore desirable to provide a new method for etching polycrystalline-amorphous SiC parasitic build-up from concerned parts of a reaction chamber without damaging said parts.

It is also desirable to provide a method for etching polycrystalline/amorphous SiC parasitic build-up that may be performed in-situ, i.e., directly in the reaction chamber without opening the latter and/or extracting it from the reactor.

It is also desirable to provide a method for in-situ etching polycrystalline/amorphous SiC parasitic build-up preventing detrimental effects on subsequent deposition processes from powder-like byproducts of the etching method.

Additionally, it would be desirable to provide a new reactor adapted to execute the above-mentioned method. Furthermore, it would be desirable to provide a reactor configured to execute said method in an automated fashion.

### SUMMARY OF THE DISCLOSURE

This summary is provided to introduce a selection of concepts in a simplified form. These concepts are described in further detail in the detailed description of example embodiments of the disclosure below. This summary is not intended to identify key features or essential features of the claimed subject matter, nor is it intended to be used to limit the scope of the claimed subject matter.

It is an object of the present invention to overcome the disadvantages of the prior art.

In particular, it is an object of the present invention to provide a method for etching a silicon carbide accretion from one or more workpieces of a reaction chamber of a reactor for the deposition of silicon carbide layers on a substrate, the method comprising the steps of:
(i) providing a silicon carbide accretion on one or more workpieces, where the silicon carbide accretion comprises silicon carbide in polycrystalline and/or amorphous form;
(ii) executing at least one cycle of an etching process comprising the steps of:
   A1. ramping the temperature of the reaction chamber to 800 - 1450 °C;
   A2. ramping the pressure of the reaction chamber to 100 - 700 mbar;
   B. delivering a reactive composition into the reaction chamber; said reactive composition comprising at least a first reactive gas and an inert gas;
(iii) executing at least one cycle of a chemical vapor deposition process in the reaction chamber comprising the step of:
   D. depositing a ceramic overlayer onto the one or more workpieces;
   where the carrier gas in step B is an inert gas; and where the first reactive gas is An inorganic chlorinated species; and where the molar concentration of the first reactive gas into the carrier gas is preferably 15 - 40%.

It is another object of the invention to provide a reactor for the deposition of silicon carbide layers on a substrate comprising:
- at least one reaction chamber comprising a gas delivery system, which comprises at least one gas inlet and at least one gas outlet;
- a heating system adapted to heat the reaction chamber to a temperature up to 1700°C, and specifically to a temperature of 800 - 1450 °C;
- a vacuum system adapted to bring the reaction chamber to a pressure equal to 1000 mbar or less, preferably to a pressure between 100 - 1000 mbar;
where the reactor is configured to perform the method according to any of the preceding claims; and where the at least one gas inlet is connectable or connected to a source of the first reactive gas and is connectable or connected to a source of the carrier gas; and where at least one gas outlet is configured to discharge the gaseous phase byproducts of step (ii) and step (iii).

The main objectives hereinbefore described are achieved through the invention recited in the appended claims, which constitute an integral part of the present description.

It is noted that the use of reference signs in the claims does not limit their scope. The sole purpose of reference signs is to make the claims easier to understand.

### BRIEF DESCRIPTION OF THE FIGURES

The illustrations presented herein are not meant to be actual views of any particular material, structure, or device, but are merely idealized representations that are used to describe embodiments of the disclosure.
FIG. 1 is a block diagram schematically illustrating the method according to an embodiment of the present invention.
FIG. 2 is a block diagram schematically illustrating another embodiment of the method of the present invention.
FIG. 3 is a block diagram schematically illustrating another embodiment of the method of the present invention.
FIG. 4 is a block diagram schematically illustrating another embodiment of the method of the present invention.
FIG. 5 is a block diagram schematically illustrating particulars of a detail of the method of FIG. 4.
FIG. 6 is a block diagram schematically illustrating another embodiment of the method of the present invention.
FIG. 7 schematically illustrates a longitudinal view of the reaction chamber according to an embodiment of the present invention.
FIG. 8 schematically illustrates a transverse view of the reaction chamber according to an embodiment of the present invention.
FIG. 9 provides a simplified scheme of a reactor layout according to an embodiment of the present invention.
FIG. 10 provides a grayscale picture of a parasitic silicon carbide accretion deposited on a spare part of the reaction chamber.

### DETAILED DESCRIPTION OF EXEMPLARY EMBODIMENTS

Although certain embodiments and examples are disclosed below, it will be understood by those in the art that the invention extends beyond the specifically disclosed embodiments and/or uses of the invention and obvious modifications and equivalents thereof. Thus, it is intended that the scope of the invention disclosed should not be limited by the particular disclosed embodiments described below.

Reference will now be made to the Figures wherein like reference numerals identify similar structural features or aspects of the subject disclosure.

It will be appreciated that elements in the figures are illustrated for simplicity and clarity. In particular some elements may have been omitted or may have not necessarily been drawn to scale. For example, the dimensions of some of the elements in the figures may be exaggerated relative to other elements to help improve understanding of illustrated embodiments of the present disclosure.

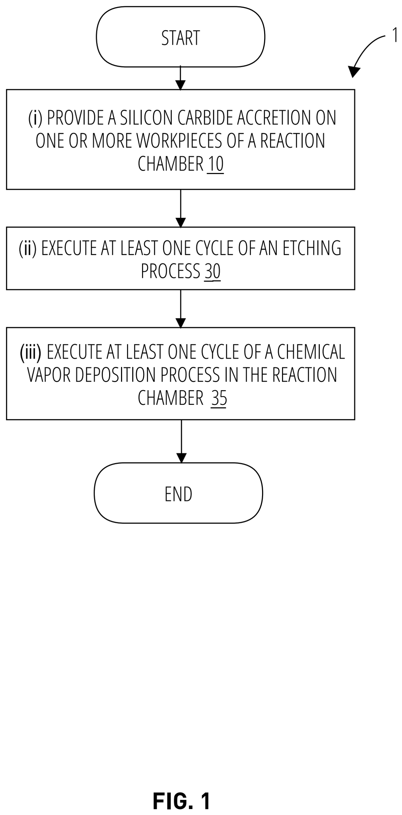

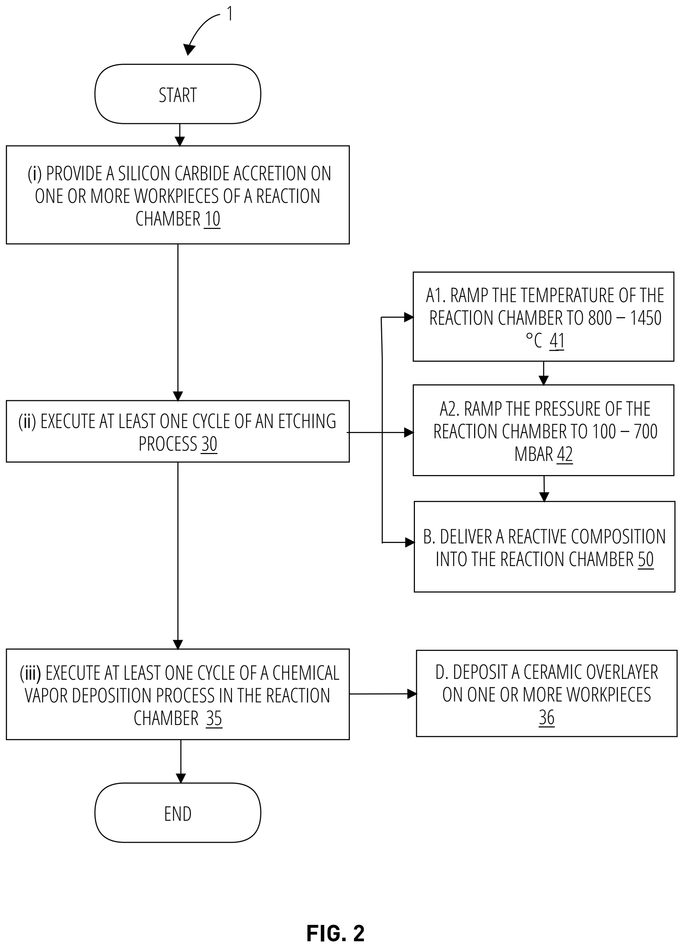

Under a first aspect, the present invention relates to a Method 1 for etching a silicon carbide accretion from one or more workpieces of a reaction chamber of a reactor suitable for the deposition of silicon carbide layers on a substrate, as outlined in FIG. 1 and FIG. 2.

The method comprises steps (i)-(iii) listed below.

Step (i) comprises providing a Silicon carbide accretion 121 on one or more workpieces 120 (block 10), where the silicon carbide accretion comprises silicon carbide in polycrystalline and/or amorphous form.

Step (ii) comprises executing at least one cycle of an etching process (block 30).

The etching process comprises the steps of:
A1. ramping the temperature of the reaction chamber to 800-1000 °C or 1000 - 1450 °C (block 41), extremes included;
A2. ramping the pressure of the reaction chamber to 100 - 150 mbar or 150 - 700 mbar (block 42);
B. delivering a reactive composition into the reaction chamber (block 50).

The reactive composition comprises one or more reactive gases, i.e., gases suitable to react with Si and/or C for etching purposes.

In particular the reactive composition comprises at least a first reactive gas and a carrier gas, where the carrier gas is an inert gas, and the first reactive gas is an inorganic chlorinated species. For example, the inert gas may be nitrogen, or, preferably, helium or argon to avoid contamination of the chamber.

The first reactive gas reacts with the silicon carbide accretion thereby creating byproducts, which may be in gaseous phase and/or in particulate form

The carrier gas may be advantageously used to tailor and control the concentration and distribution of reactive gases in the chamber.

Preferably, the molar concentration of the first reactive gas into the carrier gas is 15 - 40%.

Step (iii) comprises executing at least one cycle of a chemical vapor deposition (CVD) process in the reaction chamber (block 35), which includes the step of:
D. depositing a ceramic overlayer onto the one or more workpieces (block 36), where the overlayer is adapted to incorporate byproducts of the etching process in particulate form.

The "CVD process" carried out in step (iii) will be referred to as "particulate capture process" or "capture process", to distinguish it from the nominal deposition process of depositing SiC layers on a substrate for which the reaction chamber is primarily conceived and operated. This "nominal deposition process" may be, for example, a CVD process or an epitaxial process, but it will typically entail different process conditions (in terms of temperature, pressure, running time, and/or precursors) than the "capture process."

The "capture process" serves a different purpose and achieves a different effect than the "nominal deposition process". In particular, the "capture process" provides an overlayer that incorporates powders and particles on the one or more workpieces in the reaction chamber.

The inventors have observed that by using a molar concentration of the first reactive gas into the carrier gas of 15 - 40%, under the temperature and pressure conditions set forth above, it is possible to remove the parasitic SiC deposits without detriment to the coated/uncoated graphite parts concerned. The removal of the parasitic SiC deposits is not necessarily carried out until reaching 100% removal. Advantageously, deposits may be removed to a degree suitable to recreate adequate operating conditions inside the reaction chamber, thereby extending operation time in between PM operations.

By "etching process" it is meant the process of chemically removing silicon carbide accretions from a workpiece.

The etching process may remove SiC accretions by creating volatile, chloride-based reaction products that evaporate from the workpiece surface. It is noted that during the etching process the inorganic chlorinated species react with the silicon carbide accretions thereby creating byproducts, which may be in gaseous phase and/or in particulate form.

The inorganic chlorinated species may comprise or consist of HCl, Cl₂, ClF₃, or CCl₄.

For example, when the inorganic chlorinated species is Cl₂, under the pressure and temperature conditions inside the reaction chamber of the etching process, the etching process may be represented as: SiC + 4Cl₂ → SiCl₄ + CCl₄.

Therefore, advantageously, Cl₂ forms chlorine radicals, which attack the SiC accretion without excessive damage to the workpiece.

In this case, Cl₂ may be selected with a purity equal to or greater than 99.990%, even more preferably with a purity equal to or greater than 99.998%.

The gaseous byproducts of the etching process may exit the reaction chamber through dedicated outlets, which may be also used to discharge exhaust gases and/or unreacted gases from the etching process and optionally any other process carried out in the chamber (such as deposition, cooling, and purging processes).

During the etching process, however, also other reactions may occur and lead to the formation of byproducts in particulate form, which are not discharged with the gaseous byproducts through the outlets.

By "byproducts in particulate form" it is meant a solid, powder-like residue with variable grain size and composition.

These solid byproducts can interfere with subsequent nominal deposition processes.

They can be removed by executing other cycles of the etching process, or by using more aggressive etching conditions and/or reactive gases, but this may damage the reaction chamber parts.

Depositing a ceramic overlayer onto the reaction chamber parts (workpieces) allows to address the issue above without detriment to these parts, and without interfering with subsequent nominal deposition processes carried out in the reaction chamber.

For the avoidance of doubt, above and in the following, by "overlayer" it is meant a ceramic coating formed by CVD onto the workpieces 120, with the overlayer being suitable for embedding the solid byproducts of the etching process to prevent them from contaminating the reaction chamber during further deposition processes.

By "etching" it is meant chemical etching, i.e., a process for the chemical cleaning/removal of SiC parasitic accretions.

By "workpiece" it is meant a reaction chamber part having at least one surface exposed to process gases.

The "silicon carbide accretion" refenced herein is directly obtained or obtainable as parasitic deposition of SiC on reaction chamber parts, i.e., workpieces, during the (nominal) deposition process of SiC layers on a rotating substrate.

The "silicon carbide accretion" thus obtained comprises silicon carbide in polycrystalline and/or amorphous form.

The expression "silicon carbide accretion" shall be deemed equivalent to "parasitic SiC accretion," "SiC film," or "parasitic SiC deposit," unless otherwise specified.

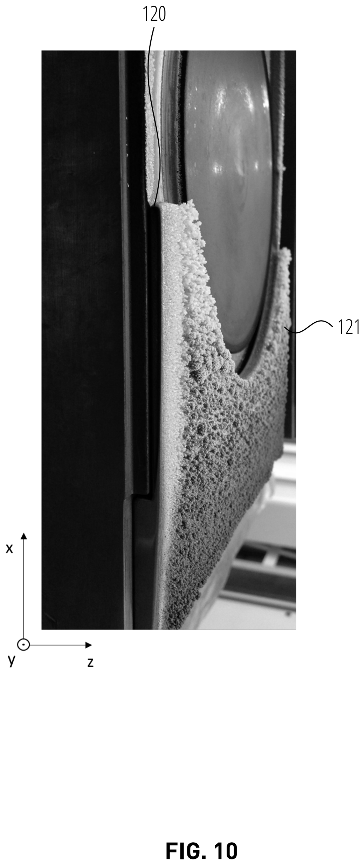

Furthermore, the term "film" in the expression above shall not imply a bi-dimensional regular and/or orderly geometry. On the contrary, it refers to an uneven SiC coating formed on one or more surfaces of impacted parts of the reaction chamber and exhibiting a three-dimensional structure, or a rough gritty surface, as evident from FIG. 10.

FIG. 10 shows a picture of a parasitic SiC accretion 121 on the workpiece 120 of a reaction chamber, positioned on the bottom wall of the reaction chamber. The workpiece is an upstream cover, surrounding an area for receiving a 6" substrate. The parasitic SiC deposit appears lighter in color in the grayscale picture compared to the other visible parts of the reaction chamber, which are made of graphite. The Silicon carbide accretion 121 coats the surface of the part 120 exposed to precursor gases with an uneven, granular, and gritty film.

These irregular features of the parasitic film become more pronounced the more the reaction chamber part is exposed to the flow of precursor gases.

The term "accretion" and "layer" are used here and in the following to respectively distinguish the undesired parasitic SiC "films" from the desired, controlled SiC "layers" deposited on a substrate during the nominal deposition process.

The present method is not limited by the specific solid-state properties of the silicon carbide accretion. The latter typically comprises or consist of a mixture of both polycrystalline and amorphous SiC, for example a mixture of polycrystalline SiC with 20 - 60% of amorphous SiC. The amount of amorphous SiC in the film may be subject to significant local and absolute variations.

The SiC layers deposited on the substrate, on the other hand, are usually monocrystalline. They are typically, though not exclusively, 3C, 4H or 6H SiC polytypes.

The parasitic SiC deposits are well-known undesired byproducts of the SiC layer deposition.

The parasitic SiC deposits occur on the surface of all parts of the reaction chamber exposed to the gas flow of SiC precursors, and especially at the upstream end of the chamber (i.e., where the precursor gases enter the reaction chamber), as well as on the elements in proximity or in contact with the substrate.

In particular, the parasitic deposition occurs on removable and fixed workpieces (covers, rings, walls), whether stationary or rotating, as the result of their exposure to SiC precursor gases during the nominal deposition process. These workpieces are often made of material with a much lower hardness than silicon carbide, for example graphite.

Advantageously, the overlayer may embed the byproducts in particulate form within its solid structure and may prevent them from contaminating and/or interfering with subsequent nominal deposition processes carried out in the reaction chamber.

Advantageously, steps (i), (ii), and (iii) described above may be be carried out directly in the reaction chamber, while the latter rests inside the reactor, with great improvement of PM times.

It is hereby noted that the workpieces form parts and components of a reaction chamber of a reactor for the deposition of silicon carbide layers on a substrate. The method of the present disclosure allows performing an in-situ etching process and, afterwards, depositing in-situ a ceramic overlayer suitable for embedding the solid byproducts of the etching process to prevent them from contaminating the reaction chamber during further deposition processes.

Therefore, the workpieces do not exit the reaction chamber during the execution of the method, which may significantly and positively impact preventive maintenance times.

Under an embodiment, during step A1 the temperature of the reaction chamber is adjusted to 1150 - 1350 °C.

Advantageously, at these temperatures, the etch rate may be controlled to balance the reactiveness of the etching process and the quantity of byproducts in particulate form, if any.

Additionally, in this temperature range the ratio of Si and C etching by chlorine radicals is optimized with respect to the overall etching process itself. The higher the temperature, the more prevalent the Si etching becomes, while at lower temperatures the etching process is overall less effective.

With great advantage, the method above described can be used for the in-situ and ex-situ etching of SiC accretions from one or more workpieces of a reaction chamber.

For what concerns the in-situ etching applications, the possibility to chemically clean the reaction chamber after parasitic build-up and to set it in adequate operating conditions without the need to: (a) open the reactor, (b) remove the reaction chamber, and (c) expose its parts to air for cleaning, is a considerable improvement with respect to the current mechanical cleaning techniques.

Surprisingly, despite the unique and challenging properties of SiC, it is possible to effectively remove up to hundreds of microns of hard, disorderly parasitic build-up without damaging the underlying parts of the reaction chamber.

The above method answers the long-felt need in the industry of providing a method for in-situ cleaning the reaction chamber of a SiC reactor from parasitic deposits.

Under an embodiment, the ceramic overlayer has a grain size lower than 300 µm, preferably lower than 20 µm, and preferably between 0.1-15 µm, as measured by visual inspection of SEM images.

Advantageously, an overlayer having the relatively small grain size as hereinbefore described may more easily grow around the particles of the solid byproducts of the etching process, which may lead to a more successful incorporation thereof.

Under an embodiment, the ceramic overlayer comprises or consists of pyrolytic graphite, silicon carbide or boron nitride.

Advantageously, these materials may provide an overlayer adapted to withstand the subsequent epitaxial SiC deposition process inside the reaction chamber and avoid or minimize contamination of the reaction chamber.

Under an embodiment, the ceramic overlayer includes or consists of polycrystalline SiC, and step D includes the following sub-steps:
D1. adjusting the temperature of the reaction chamber to 1150-1400 °C; and
D2. adjusting the pressure of the reaction chamber to 50-500 mbar; and
D3. feeding a carbon source and a silicon source into the reaction chamber with C/Si = 0.6-3, preferably 1-3.

Any sub-step D1-D3 may be carried out sequentially and/or simultaneously.

Steps D1-D3 may be executed until depositing a poly-crystalline SiC overlayer having a thickness suitable to embed the powdery byproducts, if any, such as for example a thickness up to 20 µm.

The process above and may advantageously provide a high density overlayer, for example a coating with density above 3000 kg/m³, and preferably a density close to the density of monocrystalline SiC (3200 kg/m³).

Under an embodiment, the etching process further comprises step A3, to be carried out before step B, with:
A3. flowing an inert gas into the reaction chamber.

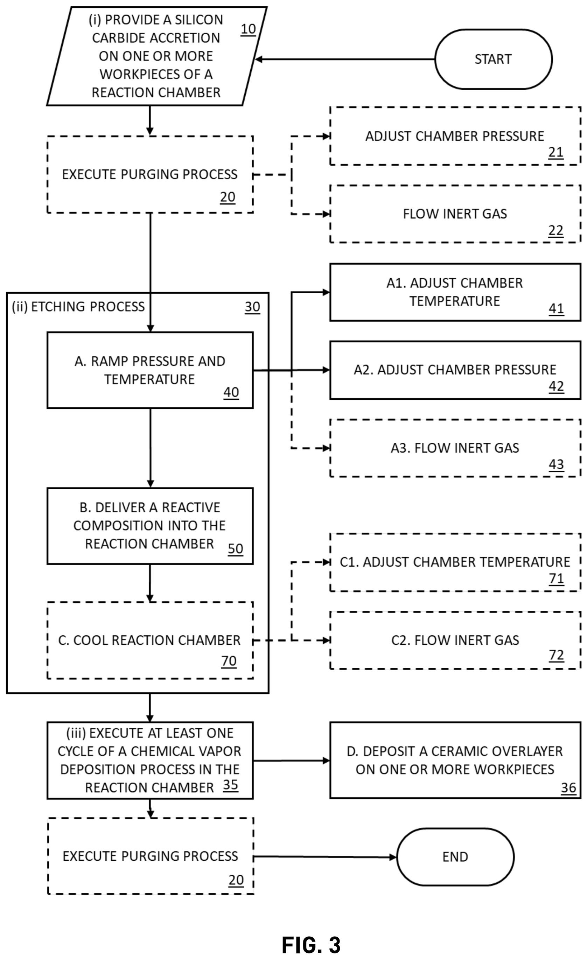

All sub-steps A1-A3 above (respectively set out in blocks 41, 42, 43 of FIG. 3) may be performed in any order, including simultaneously.

Steps A1, A2, and optional step A3 may be considered sub-steps of a general step A (block 40) of ramping the reaction chamber to preset etching process conditions; whereas step B is the step where the actual etching of the silicon carbide accretion takes place.

During step A, pressure and temperature conditions inside the reaction chamber are gradually adjusted from a starting value to the desired value, thereby protecting the reaction chamber from the undesired effects of abrupt changes. These may cause stress and damage to mechanical parts, and/or cause lack of uniformity of process conditions inside the reaction chamber.

Once the reaction chamber has reached the desired temperature and pressure settings, the actual etching of the SiC parasitic film can take place according to step B.

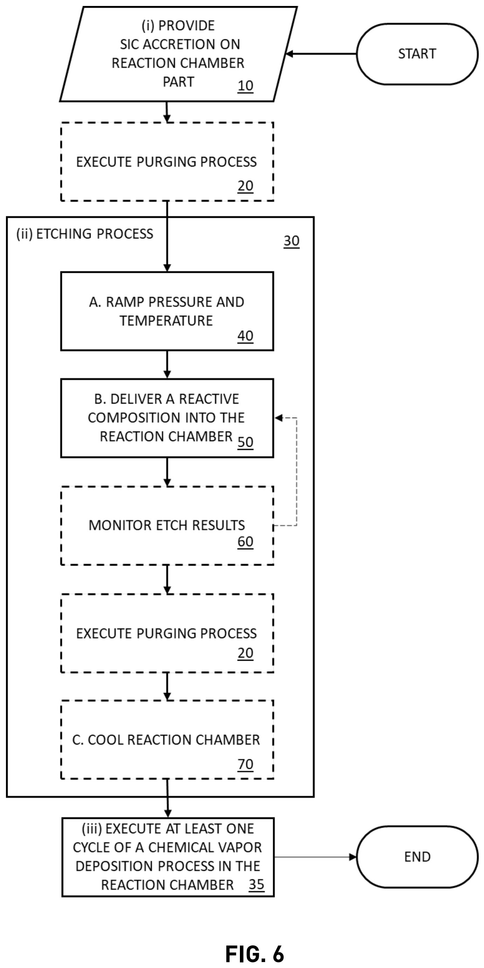

Under an embodiment, the etching process further comprises a purging process "P" (block 20 of FIG. 3, FIG. 4, FIG. 6), which comprises the following steps:
P1. adjusting the pressure of the reaction chamber to 1 mbar or less (block 21); and
P2. flowing an inert gas in the reaction chamber to reach a pressure of 100 - 1000 mbar inside the reaction chamber (block 22).

Steps P1 and P2 are executed 1 - 20 times before step A1 and A2 and/or after step B.

Advantageously, the purging process may clean the reaction chamber from the remnants of other operations and processes carried out therein.

Under an embodiment, the etching process further comprises:
C. Executing a cooling process (block 70 of FIG. 3 - FIG. 6).

This process comprises the steps of:
C1. adjusting the temperature of the reaction chamber to a value below 1000 °C (block 71, FIG. 3), preferably between 500 - 900 °C; and
C2. flowing a cooling gas at a pressure of 100 - 1000 mbar inside the reaction chamber (block 72, FIG. 3).

Steps C1 and C2 are executed after step B, and may be performed in any order, preferably simultaneously.

Step C1 may be performed by turning off the heating source and allowing the reaction chamber to cool, mostly by radiation. Step C1 may be sped up by running sub-step C2 simultaneously.

The cooling gas employed in step C2 is any gas suitable to speed up the cooling process of the chamber to idle temperature. The person with average skill in the art might easily select the most suitable gas depending on budget and time constraints. Non-limiting examples of cooling gases include helium, nitrogen, hydrogen, and combinations thereof.

After step B, and before or after step C if present, it may be beneficial to optionally execute 1 - 20 cycles of the purging process mentioned above, thus removing all traces of the reactive gases used, as well as any byproducts of the etching process that may be still present in the chamber.

The cooling step C may be advantageously used to set up favorable conditions to execute said further optional purging process, and/or the latter may help achieve the effects of the cooling step C more efficiently, depending on the order in which they are executed.

In conclusion, the optional purging process may be executed after step B and before step C as an additional step of the etching process, and/or after both step B and C once the etching process is concluded.

Under an embodiment, the flow rate of the at least first reactive gas is 5 - 15 slm (standard liter per minute). Preferably the flow rate of the at least first reactive gas is > 5 slm and < 15 slm.

Under an embodiment, the silicon carbide accretion is obtained as byproduct of one or more nominal deposition processes, for example the epitaxial deposition processes of monocrystalline SiC layers on a rotating substrate, with this process being executed in the reaction chamber of a reactor, thus leading to the accretion being formed on one or more workpieces of the reaction chamber.

The above-mentioned epitaxial deposition process is generally carried out at a pressure of 50-200 mbar and at a temperature up to 1700°C, typically above 1400, and preferably between 1450-1650 °C.

Typically, the precursor gases include Si and C precursors. For example, the silicon precursor gas may be a chlorinated compound, preferably dichlorosilane, trichlorosilane or tetrachlorosilane. The carbon precursor gas may be a hydrocarbon, in particular propane, ethylene, acetylene, or methane. Other types of Si and C precursors may be used.

Other precursors, such as for n- and p- doping may flow in the deposition unit of a reactor. For instance, the n-source may be nitrogen, acetonitrile, pyrrole, ammonia, hydrazine, hydrogen cyanide, methylamine.

It is noted that the technical properties of the SiC accretion imparted by the parasitic build up process can be adequately defined only in terms of the parasitic process per se. While the latter certainly imparts recognizable features, such as unevenness of the film and rugosity, it would be unduly limiting to characterize the SiC accretion in terms of said features.

Under an embodiment, step (i) of the method according to the invention is performed by executing one or more epitaxial deposition cycles of monocrystalline SiC layers on the same or different substrates inside a reaction chamber of a reactor, until reaching a predefined total thickness T of monocrystalline SiC layers deposited on one or more consecutive substrates during the entire operation time of the chamber, where T is preferably 100 µm - 2000 µm, even more preferably 200 - 800 µm, even more preferably 500 - 700 µm.

During this step, a parasitic silicon carbide accretion of variable an uneven thickness is formed on one or more workpieces of the reaction chamber. The silicon carbide accretion thus obtained is said to have an "equivalent thickness" T, i.e., a thickness obtained as the result of depositing orderly layers of total cumulative thickness T during the nominal deposition process.

It is noted that the local thickness of the parasitic film may greatly vary, and differ on average from T.

It is noted that the peaks of the parasitic film may be significantly higher than the thickness T, because of the dendritic-like growth of the film.

Under an embodiment, the etching process of the method according to the invention is executed for 0,12 - 0,24 minutes per µm of equivalent thickness T previously deposited on the substrates.

As previously discussed, in the art the equivalent thickness of a parasitic film is not its average or maximum thickness since the latter may be subject to significant local variation. The equivalent thickness of a parasitic film is defined as the thickness of the monocrystalline layers deposited on one or more substrates during one or more consecutive epitaxial deposition processes. As the orderly monocrystalline layers grow on a substrate, the parasitic film grows on certain parts of the reaction chamber, with variable height. It is therefore more meaningful to refer to its equivalent thickness, which is a parameter set and controlled during the reactor operation, and which can be easily measured on the actual substrates after the deposition process.

Contrary to the SiC coatings provided on the graphite parts for protection purposes, the silicon carbide accretion may exhibit a surface roughness greater than 6,3 µm Ra.

Under an embodiment, the reactive composition used in step B) further comprises a second reactive gas.

The second reactive gas may be an oxidizing agent.

The second reactive gas may be H₂ or O₂.

Under an embodiment, the molar concentration of the second reactive gas into the carrier gas is 0.1-20%. This embodiment is especially advantageous when the second reactive gas is O₂.

Under an embodiment, the molar concentration of the second reactive gas into the carrier gas is 0.1-15%.

Under an embodiment, the molar concentration of the second reactive gas into the carrier gas is 1 - 10%.

Preferably, the molar concentration of the second reactive gas into the carrier gas is lower than the molar concentration of the first reactive gas into the carrier gas.

Under some embodiments, the ratio between the molar concentration of the second reactive gas and the first reactive gas is less than 1:5.

A third reactive gas may be also used. For instance, the second and third reactive gases may be H₂ and O₂ or vice versa.

In general, depending on the type and number of reactive gases used, the byproducts in particulate form may exhibit different compositions. According to EDS measurements, when the inorganic chlorinated species is used as sole reactive gas, carbon is the main constituent (i.e., amounts to 90% or more in mass) of the solid byproduct.

In case a mixture of an inorganic chlorinated species, such as Cl₂, and an oxidizing agent, such as O₂, are used together, the main constituent of the etching byproduct in particulate form is silicon oxide.

Compared to more reactive gases, such as ClF₃, the use of less aggressive chemicals for the etching process, namely Cl₂ or a mixture of Cl₂ and O₂, followed by the deposition of an overlayer, allows to control the etch rate to lower values, and successfully annihilate the undesired effects of powdery residues.

Under an embodiment, step B) comprises the following sub-steps:
B0. optionally venting the one or more reactive gases and/or the carrier gas, i.e., by-passing the reaction chamber for a preset amount of time, for instance by flowing the one or more reactive gases and/or the carrier gas in a bypass line until reaching stationary conditions; and
B1. ramping the one or more reactive gases and the carrier gas to a respective preset nominal flowrate; and
B2. delivering the one or more reactive gases and the carrier gas into the reaction chamber at said preset nominal flowrate.

Steps B0, B1, and B2 may feature different or same start and/or duration times for each of the one or more reactive gases and for the carrier gas.

For instance, the inorganic chlorinated species may be subject to a ramp time TR1 and a time at constant value TS1, and the inert gas may be subject to a ramp time TR2 and a time at constant value TS2.

TR1, TS1, TR2, TS2 may differ from each other.

The start of the ramp time for the inorganic chlorinated species and for the inert gas may differ, and they may be subject to optional and different vent times, where the gases by-pass the reaction chamber via a by-pass line.

It is noted that all parameters mentioned in this embodiment may be provided as an input from the user or as a predefined setting. The predefined setting may be calculated based on calibration curves provided for a given reactor and on the result to be achieved. They can be obtained by the person with average skill in the art without undue burden and adapted to the specific reaction chamber design in use.

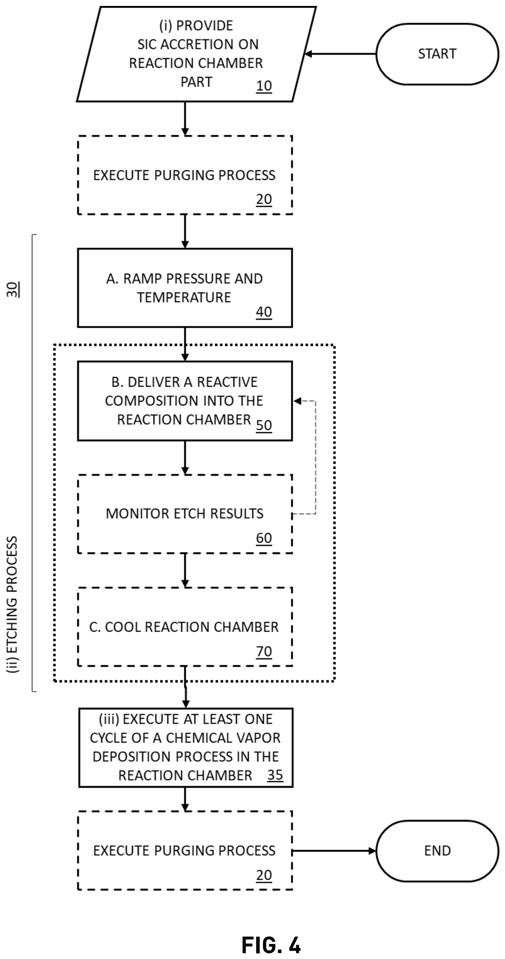

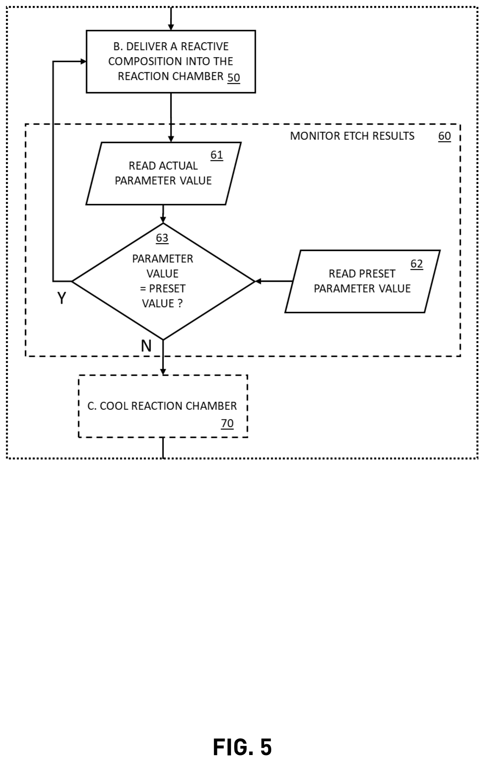

Under an embodiment, illustrated in FIG. 4 and FIG. 5, the etching process of the method according to the invention further comprises a monitoring step (block 60) and the reaction chamber 100 comprises at least one monitoring system 500 adapted to monitor an etching parameter indicative of an endpoint of the etching process.

The monitoring step is executed at the end of step B and comprises the following sub-steps:
- reading a preset target value of the etching parameter (block 62), and optionally a preset tolerance;
- reading the actual value of the etching parameter (block 61);
- checking if the actual value has reached the target value (block 63), optionally within said preset tolerance;
- repeating step B until reaching said target value (optionally within said preset tolerance).

Once the target value is achieved, the monitoring step is concluded.

The monitoring system may be a detector suitable to detect the concentration of silicon and/or carbon in the gaseous byproducts generated after each step B, such as a mass spectrometer.

Advantageously, this embodiment allows to monitor the progress of the method according to the invention.

Under an embodiment, the method according to the invention is executed in-situ to etch the silicon carbide accretion from one or more workpieces of a reaction chamber, i.e., when the reaction chamber is positioned inside the reactor and without opening the latter. To this effect, the reaction chamber may be provided with at least one gas inlet and at least one gas outlet.

In this case, during step B the reactive composition is delivered into the reaction chamber through the at least one gas inlet, thereby forming byproducts of the etching process, which may be partially or completely discharged out of the reaction chamber through the gas outlet.

Advantageously, the in-situ cleaning of the reaction chamber parts allows to drastically reduce PM times and limits the exposure of operators to the reaction chamber. Said exposure represents a safety concern that requires elaborate and time-consuming safety procedures.

Preferably but not exclusively, the reaction chamber of the present embodiment is an epitaxial reaction chamber.

According to the above embodiment, the invention relates to a method for in-situ etching a SiC accretion from one or more workpieces of a reaction chamber of a reactor for the deposition of monocrystalline silicon carbide layers on a substrate.

The method comprises the steps of:
(o) executing in the reaction chamber a deposition process, preferably an epitaxial process, of silicon carbide layers on one or more rotating substrates; thereby
(i) providing a silicon carbide accretion on one or more workpieces of the reaction chamber; wherein said reaction chamber is equipped with at least one gas inlet and at least one gas outlet;
(i_{I}) optionally executing a purging process;
(i_{II}) optionally cooling the reaction chamber to a temperature of 600-1100 °C;
(i_{III}) withdrawing the one or more processed substrates from the reaction chamber;
(i_{IV}) optionally executing a purging process;
(i_{V}) optionally inserting one or more substrates to be processed and repeating steps (o)-(i_{IV})
(ii) executing at least one cycle of an etching process in the reaction chamber, the etching process comprising the steps of:
   A. ramping the reaction chamber to preset etching process conditions;
   B. etching the silicon carbide accretion;
   C. optionally performing a cooling step;
   P. optionally executing a purging process;
(iii) executing in the reaction chamber at least one cycle of a deposition process (different than the one carried out in step (o)), where the deposition process is a chemical vapor deposition process comprising the step of:
   D. depositing a ceramic overlayer onto the one or more workpieces;
   (iii_{I}) optionally executing a purging process;
   After the last step, the above method may be stopped or repeated one or more times.

All steps above are carried out in the reaction chamber, without removing it from the reactor and without accessing it, except for the retrieval and optional insertion of one or more substrates during steps (i_{III}) and (i_{V}).

In the above method, step A comprises the sub-steps of:
A1. adjusting the temperature of the reaction chamber to 800 - 100°C or 1000 - 1450 °C; and
A2. adjusting the pressure of the reaction chamber to 100 - 150 mbar or 150 - 700 mbar;
A3. optionally flowing an inert gas into the reaction chamber;
Step B. comprises delivering a reactive composition into the reaction chamber through the gas inlet; where the reactive composition comprises one or more reactive gases and a carrier gas.

The carrier gas is an inert gas. The one or more reactive gases comprise at least a first reactive gas. The first reactive gas is an inorganic chlorinated species, and the molar concentration of the first reactive gas into the carrier gas is 15 - 40%.

The inorganic chlorinated species may be chosen from the group consisting of HCl, Cl₂, ClF₃, CCl₄, and combinations thereof.

A second reactive gas, such as O₂ or, alternatively, H₂, may be used together with the inorganic chlorinated species, and be delivered in the same reactive composition. Alternatively, the second reactive gas may be provided in a subsequent etching step B', in addition to or in substitution for the inorganic chlorinated species, and delivered in a second reactive composition also comprising a carrier gas. The relative concentration in the reactive composition of the first reactive gas, and/or the second reactive gas, if present, with respect to the carrier gas and with respect to one another, is not necessarily constant in time throughout step B (and/or B').

The deposition process at step (o) may be an epitaxial deposition process of silicon carbide, carried out at a temperature of 1450-1650 °C, and at a pressure of 50-200 mbar.

Advantageously, the method according to the invention allows to reach a removal rate of the silicon carbide accretion of 0.01 - 0.20 g/cm² per hour, without affecting the integrity of the workpieces of the reaction chamber. This parameter may be measured during calibration of the method by weighting the affected parts before and after deposition, and before and after etching, and by visual inspection.

In one embodiment, the workpieces may comprise the upper, lower, and lateral walls of the chamber, and/or the covers (upstream, lateral, and/or downstream) of said walls, if any, as well as rings, and other elements of the reaction chamber.

Under an embodiment, the reaction chamber 100 used in the method according to the invention is horizontal and of the hot-wall type (or, alternatively, of the type described in US patent application 18/953,993), and the one or more parts (workpieces) of the reaction chamber to be etched are made of graphite, optionally coated with mono- or poly-crystalline silicon carbide with a rugosity < 6,3 µm Ra. Alternatively pyrolytic graphite, diamond, quartz, and/or boron nitride may be provided as initial coatings of the workpieces.

The method hereinbefore described has been observed to work particularly well with the above reaction chamber configurations, which is particularly affected by parasitic build-up.

The parasitic build-up occurs on graphite parts that are critical to preserve. The method according to the invention is effective against parasitic SiC build-up, without damaging the graphite parts underneath, thanks to the specific process conditions herein disclosed.

Preferably, but not exclusively, the method according to the invention may be executed when the reaction chamber is of the epitaxial, horizontal, and/or crossflow type.

In any event the present invention is not limited to a specific reaction chamber design.

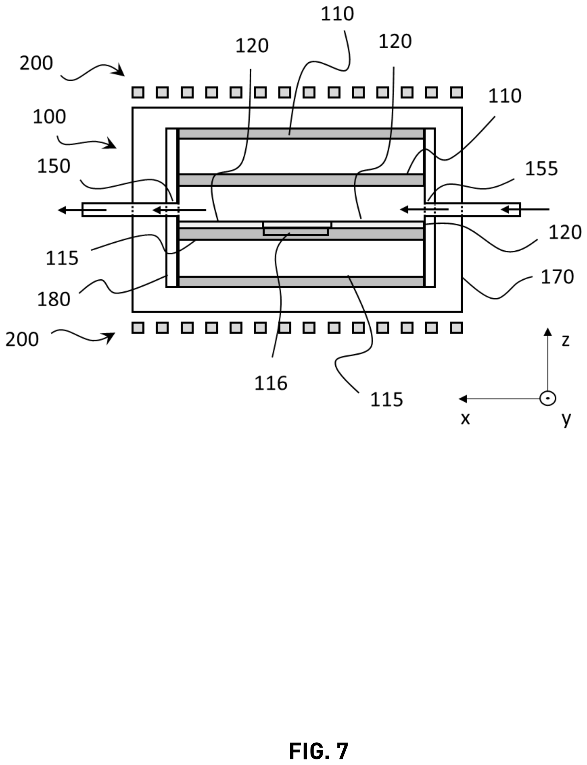

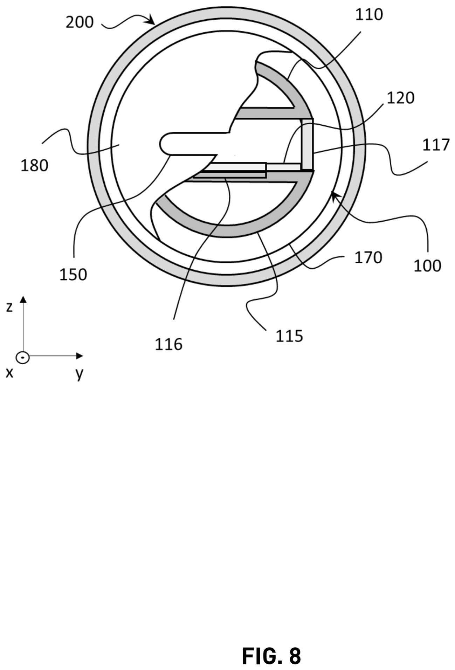

However, by way of example, in reference to FIG. 7 and FIG. 8, the reaction chamber 100 is configured for the epitaxial deposition of SiC and extends along a longitudinal direction x. The chamber may comprise an inlet 155 and an outlet 150 adapted to flow process gases, purging gases, cooling gases, and reactive compositions into and out of the reaction chamber, and over a receiving area 116 adapted to receive a substrate on a substrate holder.

The receiving area may be a recess. It may be configured to allow positioning a substrate holder.

The receiving area may be adapted to rotate a substrate holder during the epitaxial deposition process.

The chamber may be further equipped with suitable injectors, liners, nozzles, shower heads to favor the entrance and discharge of any and all gases above.

The chamber 100 may have a circular or oval cross section in a transverse plane yz perpendicular to the longitudinal direction x. The chamber may comprise an upper half-moon 110 and a lower half-moon 115, both made of graphite and separated by two lateral elements 117 made of polycrystalline SiC and having surface roughness of 0.5 - 1 µm Ra.

The chamber may comprise other parts, such as covers 120, used to protect the upper wall of the bottom half-moon 115 from SiC accretions.

The reaction chamber 100 may further comprise several insulating elements, of which only elements 180 are partially shown.

The reaction chamber 100 may further comprise a quartz enclosure 170. The quartz enclosure may be a double wall quartz tube optionally cooled with a cooling fluid such as water.

The reaction chamber 100 may be surrounded by an induction coil 200 wrapped around the quartz enclosure 170. The coil may be configured to heat the top and lower walls 110 and 115 of the reaction chamber.

Many other variants of the above reaction chamber design may be used in the execution of the present invention.

Under a second aspect, the present invention relates to a silicon carbide reactor 1000 adapted to perform the in-situ etching of silicon carbide accretions, in polycrystalline and/or amorphous form, deposited on one or more workpieces of a reaction chamber 100, according to any embodiments of the method hereinbefore described

The reactor 1000 comprises at least one reaction chamber 100 for the deposition of silicon carbide layers on a substrate, said reaction chamber being provided with a gas delivery system and comprising at least one gas inlet 155 and at least one gas outlet 150.

Preferably, the reactor 1000 comprises 1-10 reaction chambers 100, even more preferably 1-4 reaction chambers.

The reactor is connected or connectable to a source of Si and C precursors (1200 and 1250). For example, the silicon precursor gas may be a chlorinated compound, preferably dichlorosilane, trichlorosilane or tetrachlorosilane. The carbon precursor gas may be a hydrocarbon, in particular propane or ethylene or acetylene or methane. Other types of precursors may be used.

The reactor is also connected or connectable to a source of precursors for the ceramic overlayer, not shown.

Other sources, such as sources for n- and p- doping may be connected or connectable to the reactor. For instance, the n-source may be nitrogen, acetonitrile, pyrrole, ammonia, hydrazine, hydrogen cyanide, methylamine.

The reactor is also connectable or connected to a source of a reactive composition through the gas inlet 155, so that the reactive composition is delivered into the reaction chamber through the gas inlet.

The source of the reactive composition may comprise a source 1100 of the carrier gas (an inert gas, preferably Ar or He) and a source of an inorganic chlorinated species 1150.

Other sources may be present, such as sources of other reactive gases, for instance H₂ and/or O₂.

With the term "source" in general it is meant a line for gas or liquid, a cylinder, and/or a vessel.

The reactor 1000 further comprises a heating system 200 adapted to heat the reaction chamber to a temperature up to 1700°C to perform silicon carbide deposition. Specifically, the heating system 200 should be adapted to heat the reaction chamber to a temperature of 800 - 1450 °C (i.e., 800-1000 °C or 1000-1450 °C extremes included) in order to perform the etching process of the method according to the invention. It is understood that the actual temperature inside the chamber may differ depending on the chamber design, the heating system, and the number of substrates being treated.

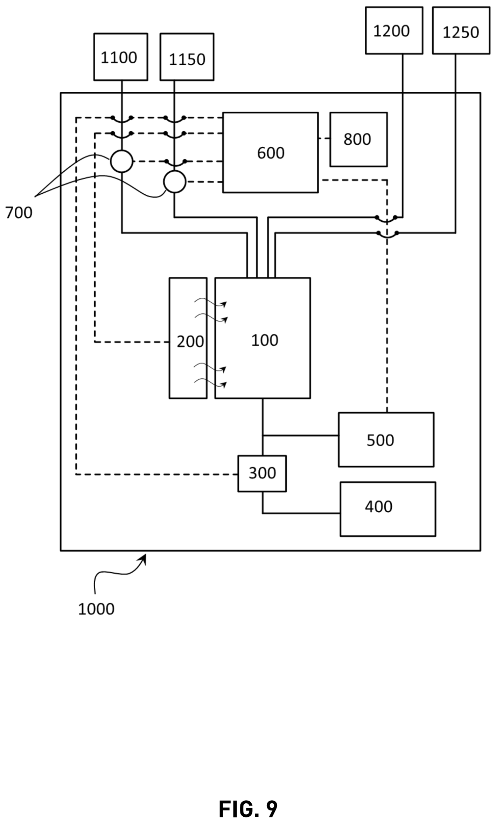

In FIG. 7- FIG. 9, the heating system is located outside the reaction chamber, but other configurations are possible.

The reactor 1000 further comprises a vacuum system 300 adapted to bring the reaction chamber to a pressure ≤ 1000 mbar, such as between 100 - 1000 mbar. The vacuum system 300 may comprise at least one pump.

The pump is suitable for (a) depressurizing the reaction chamber 100 and/or (b) flowing exhaust gases (resulting from the deposition and etching processes, and/or or cooling steps), out of the reaction chamber through the outlet 150 and into a scrubber 400. The vacuum system may further comprise at least one valve, preferably a throttle valve upstream of the vacuum pump.

The one or more gas outlets also allow discharging the byproducts of the etching process into the scrubber 400.

Advantageously, the reactor above described is adapted to execute the method according to the invention, thereby featuring reduced PM times.

Under an embodiment, the reactor 1000 further comprises: a processor 600, an accessible memory, an in-situ etching program, and optionally a capture program, adapted to run the particulate capture process, i.e., step (iii) of the method 1.

The in-situ etching program is stored as a sequence of machine language instructions in the accessible memory and adapted to perform steps A and B (and optionally step C) of the etching process of the method according to the invention.

The particulate capture program is stored as a sequence of machine language instructions in the accessible memory and adapted to perform step D of the method according to the invention.

The processor 600 is configured or configurable to execute the in-situ etching program, for instance, by actuating controls 700 operating the sources 1100 and 1150 of the reactive gas mixture.

The controls 700 may comprise a system of valves, such as throttle valves, pumps, and circuitry able to control the flow rate, timing, and absolute and relative quantity of the carrier gas and of the one or more reactive gases.

Other controls may by actuated by the processor 600 to control the flow rate, timing, and absolute and relative quantity of the ceramic overlayer precursors (not shown).

The gases used in the etching process may be combined before entering the reaction chamber 100. They may enter the reaction chamber in one stream. Alternatively, they may enter the reaction chamber in a plurality of streams with different concentrations and/or flow rates and entry times depending on their injection point and direction. To this effect, it is possible to use a plurality of inlets. Alternatively, it is possible to use one inlet attached to a liner provided with segregated areas to accommodate separate streams of gas flow.

The same applies for the different gases used in nominal deposition process, and/or for the different precursor gases used in the particulate capture process.

The processor 600 may be configured or configurable to control the vacuum system 300, via one or more valves, such as throttle valves, and circuitry.

The reactor 1000 may optionally comprise a human-machine interface 800, to allow an end user to start the etching process, adjust the relevant parameters, and optionally follow its progress.

The human-machine interface 800, may also optionally allow an end user to start the capture process, adjust the relevant parameters, and preferably follow its progress.

Under an embodiment, the reaction chamber 100 of the reactor 1000 is of the hot-wall type and comprises one or more parts made of graphite, optionally coated with monocrystalline or polycrystalline silicon carbide with a rugosity below 6,3 µm Ra (or alternatively, pyrolytic graphite, diamond, quartz, and/or boron nitride). These optional coatings have been observed to work particularly well in the execution of the invention. These coatings, which are provided ab initio with the workpieces, should not be confused with the overlayer deposited during the particulate capture process, which serves a different purpose, typically exhibits a different composition and/or morphological structure, and is carried out each time the method is performed.

The heating system 200 of the reactor 1000 may be an induction system.

The reactor may be equipped with a monitoring system 500, adapted to detect/monitor an etching parameter indicative of an endpoint of the etching process and positioned between the downstream end of reaction chamber 100 (after the gas outlet 150) and the scrubber 400 where the exhaust gases are treated.

The processor 600 may be optionally configured or configurable to read and elaborate one or more signals from the monitoring system 500 if present.

The reactor according to the invention may comprise one or more detectors for the detection of one or more reactive gases, where said detectors include systems and devices adapted to trigger an alarm or a stop signal to ensure user safety.

It is understood that the reactor according to the invention may include any or all other elements that are essential or desirable in the reactor industry, such as, without limitation: cabinetry, pipes, actuators, monitors, electric circuits, mass flow controllers, temperature sensors, valves, pumps, and/or powering means.

The subject matter of the present disclosure includes all novel and nonobvious combinations and sub-combinations of the various processes, systems, and configurations, and other features, functions, acts, and/or properties disclosed herein, as well as any and all equivalents thereof.

## Claims

1. A method for etching a silicon carbide accretion from one or more workpieces of a reaction chamber of a reactor for the deposition of silicon carbide layers on a substrate, the method comprising the steps of:
(i) providing a silicon carbide accretion on the one or more workpieces, said silicon carbide accretion comprising silicon carbide in polycrystalline and/or amorphous form;
(ii) executing at least one cycle of an etching process comprising the steps of:
A1. adjusting the temperature of the reaction chamber to 800-1450 °C;
A2. adjusting the pressure of the reaction chamber to 100 - 700 mbar;
B. delivering a reactive composition into the reaction chamber; said reactive composition comprising at least a first reactive gas and a carrier gas;
(iii) executing at least one cycle of a chemical vapor deposition process in the reaction chamber, comprising the step of:
D. depositing a ceramic overlayer onto the one or more workpieces;
wherein the carrier gas in step B is an inert gas; and wherein said first reactive gas is an inorganic chlorinated species; and wherein the molar concentration of the first reactive gas into the carrier gas is 15 - 40%.

2. The method of claim 1, wherein during step A1 the temperature of the reaction chamber is adjusted to 1150 - 1350 °C.

3. The method of claim 1 or 2, wherein in step D the ceramic overlayer has a grain size lower than 300 um, preferably lower than 20 µm.

4. The method of any one of claims 1 to 3, wherein the ceramic overlayer comprises or consists of pyrolytic graphite, silicon carbide or boron nitride.

5. The method of claim 4, wherein the ceramic overlayer comprises or consists of polycrystalline SiC, and step D comprises the following sub-steps:
D1. adjusting the temperature of the reaction chamber to 1150-1400 °C; and
D2. adjusting the pressure of the reaction chamber to 50-500 mbar; and
D3. feeding a carbon source and a silicon source into the reaction chamber with C/Si = 0.6-3;
wherein sub-steps D1-D3 may be carried out sequentially and/or simultaneously.

6. The method of any one of claims 1 to 5, wherein the etching process further comprises the following step:
A3. flowing an inert gas into the reaction chamber;
wherein step A3 is carried out before step B.

7. The method of any one of claims 1 to 6, wherein the etching process further comprises the following steps:
C1. adjusting the temperature of the reaction chamber to a value below 1000 °C; and
C2. flowing a cooling gas at a pressure of 100 - 1000 mbar inside the reaction chamber,
wherein steps C1 and C2 are executed after step B.

8. The method of any one of claims 1 to 7, wherein the etching process further comprises the following steps:
P1. adjusting the pressure of the reaction chamber to 1 mbar or less; and
P2. flowing an inert gas in the reaction chamber to reach a pressure of 100 - 1000 mbar inside the reaction chamber;
wherein steps P1 and P2 are executed 1 - 20 times before step A1 and A2 and/or after step B.

9. The method of any one of claims 1 to 8, wherein the carrier gas is nitrogen, argon, or helium.

10. The method of any one of claims 1 to 9, wherein the flow rate of the first reactive gas is 5 - 15 slm.

11. The method of any one of claims 1 to 10, wherein the silicon carbide accretion is obtained as byproduct of the epitaxial deposition process of monocrystalline silicon carbide layers on a rotating substrate executed in the reaction chamber of a reactor; said byproduct being formed on one or more workpieces of said reaction chamber.

12. The method of any one of claims 1 to 11, wherein the reactive composition further comprises a second reactive gas and, preferably, said second reactive gas is H₂ or O₂.

13. The method according to claim 12, wherein the molar concentration of the second reactive gas into the carrier gas is 0.1-20%.

14. The method of any one of claims 1 to 13, wherein said method is executed to etch the silicon carbide accretion from one or more workpieces of a reaction chamber, said reaction chamber being positioned inside the reactor; and wherein said reaction chamber is provided with at least one gas inlet and at least one gas outlet, and wherein during step B the reactive composition is delivered into the reaction chamber through the at least one gas inlet and forms byproducts of the etching process in gaseous and optionally particulate form, and wherein said gaseous byproducts are partially or completely discharged out of the reaction chamber through the at least one gas outlet.

15. The method of any one of claims 1 to 14, wherein step (i) is performed by executing one or more epitaxial deposition cycles of monocrystalline silicon carbide layers one or more substrates inside a reaction chamber of a reactor, until reaching a predefined total thickness "T" of monocrystalline silicon carbide layers deposited, where T is preferably 50 - 2000 µm, even more preferably 100 - 800 µm.

16. The method of claim 15, wherein step (ii) is executed for a duration of 0,12 - 0,24 minutes per µm of the predefined total thickness "T".

17. The method of any one of claims 1 to 16, wherein the inorganic chlorinated species comprises HCl, Cl₂, ClF₃, or CCl₄.

18. A reactor for the deposition of silicon carbide layers on a substrate comprising:
- at least one reaction chamber, said reaction chamber being provided with a gas delivery system and comprising at least one gas inlet and at least one gas outlet;
- a heating system adapted to heat the reaction chamber to a temperature up to 1700°C, and specifically to a temperature of 800 - 1450 °C;
- a vacuum system adapted to bring the reaction chamber to a pressure equal to 1000 mbar or lower, preferably between 100 - 1000 mbar;
wherein said reactor is configured to perform the method according to any of the preceding claims; and wherein said at least one gas inlet is connectable to a source of the first reactive gas and the carrier gas; wherein at least one gas outlet is configured to discharge the gaseous phase byproducts of step (ii) and step (iii).

19. The reactor for the deposition of claim 18, further comprising:
- a processor;
- an accessible memory;
- an in-situ etching program stored as a sequence of machine language instructions in the accessible memory, said program being adapted to perform at least steps A1, A2, and B of the etching process;
wherein the processor is configurable to execute the in-situ etching program.
